(19) Europäisches Patentamt
European Patent Office
Office européen des brevets

(11) **EP 3 350 608 B1**

(12) **FASCICULE DE BREVET EUROPEEN**

(45) Date de publication et mention
de la délivrance du brevet:
**19.06.2019 Bulletin 2019/25**

(21) Numéro de dépôt: **16774534.8**

(22) Date de dépôt: **13.09.2016**

(51) Int Cl.:
*G01R 31/34* (2006.01)   *H01R 39/58* (2006.01)
*H02K 11/20* (2016.01)

(86) Numéro de dépôt international:
**PCT/FR2016/052298**

(87) Numéro de publication internationale:
**WO 2017/046502 (23.03.2017 Gazette 2017/12)**

(54) **PROCEDE DE LIMITATION DE L'USURE DES BALAIS DE MOTEUR ELECTRIQUE**

VERFAHREN ZUM BEGRENZEN DES VERSCHLEISSES VON ELEKTROMOTORBÜRSTEN

METHOD FOR LIMITING WEAR OF ELECTRIC MOTOR BRUSHES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.09.2015 FR 1558672**

(43) Date de publication de la demande:
**25.07.2018 Bulletin 2018/30**

(73) Titulaire: **Renault S.A.S.**
**92100 Boulogne-Billancourt (FR)**

(72) Inventeurs:
• **NGUYEN, Thanh**
**78470 Saint-remy-les-chevreuse (FR)**
• **GAUTHEROT, Christophe**
**78180 Montigny-le-bretonneux (FR)**
• **MARSILIA, Marco**
**92100 Boulogne-billancourt (FR)**

(56) Documents cités:
**DE-U1-202006 019 888      JP-A- H1 094 287
JP-A- S62 155 745       JP-A- 2011 151 890
US-A- 5 177 419**

**Description**

La présente invention se rapporte au domaine des moteurs électriques à balais et de l'industrie automobile.

Les groupes motopropulseurs électriques comprennent au moins un moteur électrique relié à un système d'électronique de puissance permettant d'alimenter le moteur en courant alternatif à partir d'une batterie d'accumulation électrique dite batterie de traction, le pilotage de l'ensemble étant réalisé par un calculateur dédié. Le moteur électrique est constitué d'un rotor mobile et d'un stator fixe. Dans le cas d'une machine électrique disposant de balais : par exemple une machine électrique à rotor bobiné, les balais permettent en mode traction d'alimenter les bobinages du rotor et en mode charge de transférer l'électricité produite par lesdits bobinages du rotor.

Parmi les éléments les plus critiques pour ce type de moteur électrique se trouvent les balais or une usure (dégradation des balais liée à leur utilisation se traduisant par une perte de matière sur les balais, l'usure s'exprimant en unité de distance) excessive desdits balais provoque une panne, se traduisant par un arrêt dudit moteur, et nécessite son remplacement. Le brevet US 5177419 propose, pour un véhicule de levage électrique, une stratégie d'inhibition de certaines directions d'élévation si l'usure des balais devient trop importante. Or dans le cas d'un moteur électrique de traction de véhicule électrique, cette stratégie consisterait en l'inhibition de la traction ce qui immobiliserait ledit véhicule électrique.

Un des buts de l'invention est de remédier à au moins une partie des inconvénients de la technique antérieure en fournissant un procédé de limitation de l'usure des balais d'un moteur électrique, de traction ou de propulsion, d'un véhicule électrique ou hybride qui empêche une usure excessive desdits balais pendant la durée de vie prévue dudit moteur électrique équipant un véhicule. Pour ce faire, l'invention s'appuie sur la connaissance de la proportionnalité directe au régime moteur et à la valeur absolue du couple de la vitesse d'usure desdits balais. Il en découle que les balais d'un moteur électrique à rotor bobiné s'usent plus vite, lorsque la puissance mécanique, qui est le produit du couple et du régime moteur, est plus élevée. L'invention limite donc l'usure desdits balais par un contrôle de la puissance mécanique maximale dudit moteur.

A cette fin, l'invention propose un procédé de limitation de l'usure des balais d'un moteur électrique d'un véhicule électrique ou hybride comportant:

- une étape d'estimation de l'usure desdits balais,
- une étape de limitation d'une puissance mécanique maximum autorisée pour ledit moteur en fonction de ladite usure estimée desdits balais à partir d'un seuil d'usure desdits balais,

caractérisé en ce que ledit seuil d'usure, au-delà duquel ladite limitation de puissance mécanique est effectuée, est fonction du temps cumulé d'utilisation desdits balais.

Grâce à l'invention, l'usure contrôlée desdits balais limite le risque de panne dudit moteur électrique. Cette invention s'applique à un moteur électrique à balais qu'il soit de traction d'un véhicule électrique ou hybride ou, en variante, de compresseur électrique de système de climatisation d'un véhicule. Dans le cas d'un moteur électrique de traction pour véhicule électrique cela protège de la panne immobilisante liée au dépassement du seuil d'usure maximum desdits balais pendant la durée de vie prévue dudit véhicule. En outre, cette invention permet de ne pas changer le dimensionnement physique desdits balais dudit moteur dans le cas d'un allongement de ladite durée de vie prévue du véhicule puisque ledit procédé ne requiert qu'une mise à jour d'un calculateur du véhicule.

Selon une caractéristique avantageuse du procédé selon l'invention, ledit temps cumulé d'utilisation desdits balais est pris égal à la distance totale parcourue par ledit véhicule avec lesdits balais. Le procédé ainsi décrit est le mode de réalisation préféré adapté audits moteurs électriques de traction des véhicules électriques ou hybrides.

Selon une autre caractéristique avantageuse, ladite étape d'estimation de l'usure desdits balais, comporte au moins :

- une étape de réception d'une requête de couple, d'une mesure du régime moteur et d'une tension d'alimentation aux bornes dudit moteur électrique,
- une étape d'estimation d'un courant d'excitation dudit moteur en fonction de ladite requête de couple, de ladite mesure du régime moteur et de ladite tension,
- une étape d'estimation de la vitesse d'usure des balais en fonction dudit courant d'excitation estimé et dudit régime moteur,
- une étape de calcul d'usure des balais (w) par intégration temporelle de ladite vitesse d'usure des balais.

Un tel procédé d'estimation d'usure desdits balais utilise des données d'entrée déjà connues et disponibles dans un calculateur de véhicule et ne nécessite donc pas l'ajout de nouveaux capteurs physiques.

Selon une autre caractéristique avantageuse, l'étape de limitation de la puissance mécanique comporte au moins :

- une étape de calcul dudit seuil d'usure des balais,
- une étape de comparaison de ladite usure des balais estimée audit seuil d'usure des balais,
- une étape de limitation de ladite puissance mécanique dudit moteur lorsque ladite usure des balais est supérieure audit seuil d'usure des balais.

Un tel procédé modulaire peut être hébergé de manière répartie dans différents calculateurs.

Selon une autre caractéristique avantageuse, ledit seuil d'usure des balais, formant la limite inférieure de la zone de limitation de puissance dans le plan temps d'utilisation - usure desdits balais, est défini par rapport à une droite d'usure théorique desdits balais dont l'abscisse est ledit temps d'utilisation des balais, dont l'ordonnée à l'origine est l'usure nulle et dont l'ordonnée correspondant à un temps prédéterminé d'utilisation desdits balais est l'usure maximum desdits balais provoquant une panne immobilisante dudit moteur. Une telle définition de la zone de limitation de puissance est adaptée à chaque dit moteur.

Selon une autre caractéristique avantageuse, ledit seuil d'usure des balais est une courbe constituée de trois segments de droite dont :

- le premier segment de droite est de pente nulle et son ordonnée vaut une valeur d'usure basse, en dessous de laquelle aucune limitation de puissance n'est nécessaire, et ce segment s'achève à son intersection avec ladite droite d'usure théorique desdits balais,
- le second segment de droite est de pente inférieure ou égale à celle de ladite droite d'usure théorique des balais, et s'achève à son intersection avec le troisième segment de droite,
- le troisième segment de droite est de pente nulle et son ordonnée vaut le seuil maximum d'usure desdits balais auquel on a retranché une marge d'appréciation.

Une telle définition de la courbe de seuil d'usure est adaptable à chaque type de balais.

Selon une autre caractéristique avantageuse, dans une sous-partie de la zone de limitation de puissance située sous ladite droite d'usure théorique desdits balais et sous le seuil maximum d'usure des balais auquel on a retranché ladite marge d'appréciation une limitation de puissance n'est appliquée que si un seuil prédéterminé de puissance mécanique a été dépassé un nombre de fois prédéterminé depuis le réveil du véhicule. Une telle stratégie s'adapte à la conduite de chaque conducteur et permet de ne limiter ladite puissance mécanique maximale autorisée audit conducteur uniquement quand nécessaire.

Selon une autre caractéristique avantageuse, la valeur de ladite limitation de puissance mécanique dudit moteur peut varier en fonction de la position de ladite usure à un temps d'utilisation donné dans ladite zone de limitation de puissance. Une telle dépendance au profil d'usure desdits balais permet une restriction progressive de la puissance mécanique maximale autorisée audit conducteur avec la dégradation desdits balais.

L'invention concerne aussi un dispositif de limitation de l'usure des balais d'un moteur électrique d'un véhicule comportant:

- un moyen d'estimation de ladite usure des balais,
- un moyen de limitation d'une puissance mécanique maximum autorisée pour ledit moteur en fonction de ladite usure estimée desdits balais à partir d'un seuil d'usure desdits balais,

caractérisé en ce que ledit seuil d'usure, au-delà duquel ladite limitation de puissance mécanique est effectuée, est fonction du temps cumulé d'utilisation desdits balais. Ce dispositif présente des avantages analogues à ceux du procédé.

L'invention concerne aussi un programme de calculateur comprenant des instructions pour mettre en oeuvre les étapes dudit procédé de limitation de l'usure des balais d'un moteur électrique d'un véhicule selon l'invention, lorsque ledit programme est exécuté sur un ordinateur. Un tel programme est implanté dans ledit calculateur véhicule, le procédé ainsi fourni est d'application peu coûteuse.

D'autres caractéristiques et avantages apparaîtront à la lecture d'un mode de réalisation préféré décrit en référence aux figures dans lesquelles:

- la figure 1 représente un logigramme du procédé de limitation de l'usure des balais d'un moteur électrique selon un mode de réalisation de l'invention ;
- la figure 2 représente un exemple de dispositif conforme à l'invention ;
- la figure 3 est la représentation dans les axes usure et distance parcourue par le véhicule de la zone de limitation de puissance mécanique ; et,
- la figure 4 représente la répartition de différentes stratégies de limitation de puissance mécanique dans la zone de limitation.

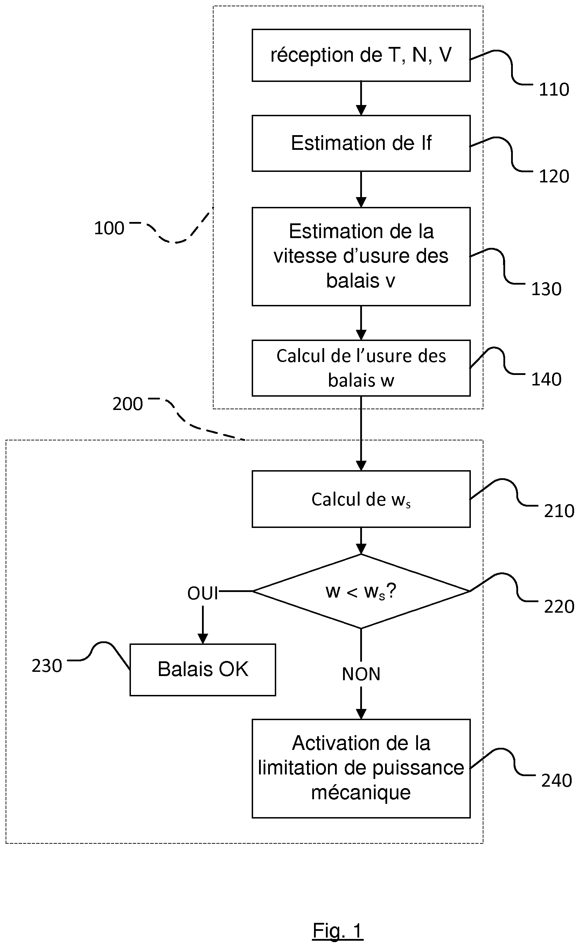

Selon un premier mode de réalisation de l'invention représenté dans le logigramme de la **figure 1,** le procédé est constitué de deux étapes, la première étape 100 consiste en l'estimation en temps réel de l'usure des balais w puis la seconde qui utilise le résultat de la précédente est une étape 200 de limitation d'une puissance mécanique maximum autorisée pour ledit moteur. Chacune de ses étapes est divisée en sous-étapes, ainsi la première étape 100 commence par la sous-étape 110 de réception d'une requête de couple T (en N.m), d'une mesure du régime moteur N (en rpm) et d'une tension d'alimentation V (en V) aux bornes dudit moteur électrique. Ces grandeurs caractéristiques sont communément utilisées pour la gestion de l'énergie électrique des véhicules électriques ou hybrides et constituent donc des entrées disponibles ne nécessitant pas l'ajout de nouveaux capteurs. Cette sous-étape est suivie de la seconde sous-étape 120 d'estimation d'un courant d'excitation If dudit moteur en fonction de ladite requête de couple T, de ladite mesure du régime moteur N et de ladite tension V. Cette estimation se fait par exemple en utilisant des cartographies du courant d'excitation If (en A) en fonction des paramètres précédemment mentionnés. La sous-étape 130 suivante consiste en l'estimation de la vitesse d'usure des balais v en fonction dudit courant d'excitation If estimé et dudit régime moteur N. Ladite sous-étape 130 s'appuie sur le fait que la vitesse d'usure des balais v (en mm/s), varie de manière connue, reproductible et mesurable en fonction du courant d'excitation If et du régime moteur N. Un exemple de réalisation de cette sous-étape 130 utilise une cartographie de ladite vitesse en fonction dudit courant d'excitation If et dudit régime moteur N. La dernière sous-étape 140 de calcul en temps réel de ladite usure des balais w (en mm) consiste en l'intégration temporelle cumulée de ladite vitesse v d'usure des balais depuis la mise en service dudit véhicule muni dudit moteur électrique avec lesdits balais. C'est-à-dire qu'à chaque pas de temps on calcule l'intégrale temporelle de ladite vitesse v d'usure des balais à laquelle on ajoute l'usure obtenue au pas de temps précédent pour obtenir l'usure du pas de temps courant. La seconde étape 200 se divise elle-même aussi en sous-étapes, la première sous-étape 210 est le calcul du seuil d'usure desdits balais $w_s$ (en mm) au-delà duquel une stratégie de limitation de la puissance mécanique est appliquée. La seconde sous-étape 220 de comparaison de ladite usure estimée w des balais audit seuil $w_s$ d'usure desdits balais implique deux possibilités :

- soit ladite usure estimée des balais w est inférieure audit seuil $w_s$ d'usure des balais, auquel cas la sous-étape 230 n'applique alors aucune limitation de ladite puissance mécanique dudit moteur,
- soit ladite usure estimée des balais w est supérieure ou égale audit seuil $w_s$ d'usure des balais, auquel cas la sous-étape 240 applique une stratégie de limitation de ladite puissance mécanique dudit moteur.

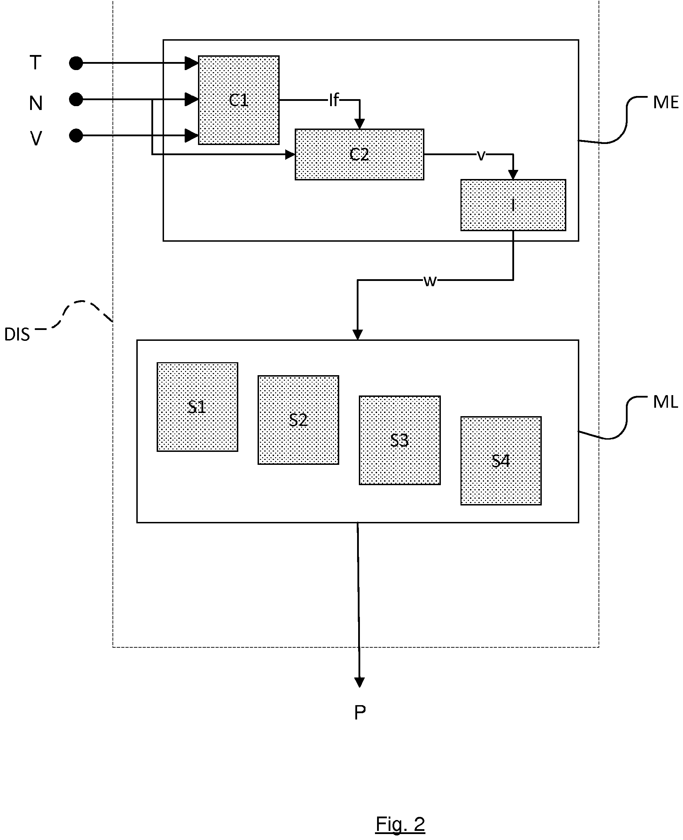

Sur la **figure 2** est représenté le dispositif DIS de limitation de ladite usure estimée des balais w dudit moteur électrique d'un véhicule comportant un premier moyen d'estimation ME de ladite usure des balais w. Ledit moyen d'estimation ME consomme en entrée d'une cartographie C1 ladite requête de couple T, ladite mesure du régime moteur N et ladite tension V, ces entrées de ladite cartographie C1 permettent d'évaluer ledit courant d'excitation If. Ledit courant d'excitation If et ladite tension V entrent alors dans une seconde cartographie C2 dont la sortie est la vitesse v d'usure des balais. Un bloc intégrateur I calcule ladite usure estimée w cumulée depuis la mise en service dudit véhicule disposant dudit moteur électrique avec lesdits balais. Ce résultat sert alors d'entrée au second moyen de limitation ML d'une puissance mécanique maximum autorisée dudit moteur qui contient différentes stratégies de limitation de ladite puissance mécanique: S1, S2, S3 et S4. En sortie dudit moyen de limitation ML on obtient la puissance mécanique maximale P disponible pour le conducteur.

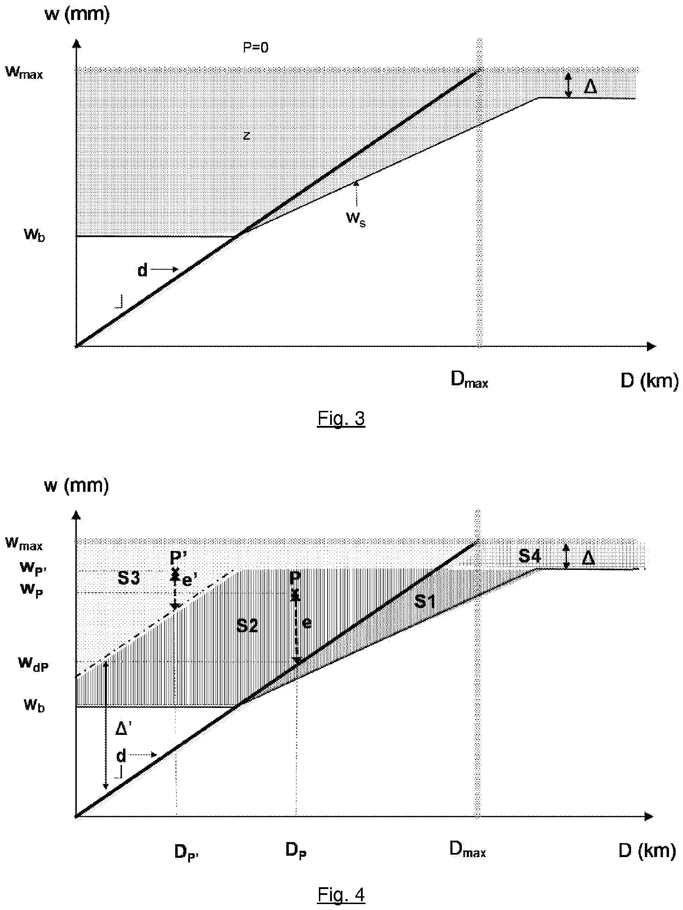

Sur la **figure 3** est représentée la zone z de limitation de puissance mécanique dans un plan dont l'axe des abscisses est la distance D, en kilomètres, parcourue par le véhicule depuis la mise en service dudit véhicule disposant dudit moteur électrique avec lesdits balais et dont l'axe des ordonnées est ladite usure estimée w desdits balais, en millimètres. Dans cette figure adaptée au mode de réalisation préféré pour moteur électrique de véhicule électrique le temps cumulé d'utilisation desdits balais est pris égal à la distance D totale parcourue par ledit véhicule muni dudit moteur électrique avec lesdits balais. Ladite zone z de limitation de puissance est tracée à partir d'une droite d d'usure théorique desdits balais et d'une courbe décrivant le seuil $w_s$ d'usure desdits balais. Ladite droite d d'usure théorique desdits balais représente un profil d'usure théorique en fonction de ladite distance D parcourue évitant la panne immobilisante liée à une usure excessive desdits balais jusqu'au kilométrage maximum prévu $D_{max}$ (en km) du véhicule. Dans l'exemple ladite droite d a pour ordonnée à l'origine l'usure nulle et pour ordonnée audit kilométrage maximum prévu $D_{max}$ le seuil d'usure maximum $w_{max}$ (en mm) desdits balais provoquant une panne immobilisante dudit moteur se traduisant par une puissance mécanique nulle P=0 kW. Ladite zone z de limitation de puissance a pour limite inférieure ladite courbe décrivant le seuil $w_s$ d'usure desdits balais composée de trois segments de droite dont :

- le premier segment de droite est de pente nulle et son ordonnée vaut une valeur d'usure basse wb (en mm), en dessous de laquelle aucune limitation de puissance n'est nécessaire, et ce segment s'achève à son intersection avec ladite droite d d'usure théorique desdits balais,
- le second segment de droite est de pente inférieure ou égale à celle de ladite droite d d'usure théorique des balais, et s'achève à son intersection avec le troisième segment de droite,

- le troisième segment de droite est de pente nulle et son ordonnée vaut ledit seuil d'usure maximum $w_{max}$ desdits balais auquel on a retranché une marge d'appréciation $\Delta$ (en mm). La limite supérieure de ladite zone z de limitation est considérée comme la droite de pente nulle et d'ordonnée valant ledit seuil d'usure maximum $w_{max}$ puisqu'au-delà ladite machine électrique cesse de fonctionner mettant ledit véhicule en panne immobilisante.

Sur la **figure 4** est représentée dans le plan usure - distance parcourue ladite zone z de limitation divisée en 4 sous-zones S1, S2, S3 et S4 qui représentent les différentes stratégies de limitation de puissance mécanique. La stratégie de limitation S1, S2, S3 ou S4 adoptée dépend ainsi de la position de l'usure estimée w dans ledit plan usure - distance parcourue. Les différentes stratégies limitent ladite puissance mécanique maximale P disponible pour le conducteur par un seuil de puissance. Ledit seuil de puissance varie en fonction de la position de ladite usure estimée w dans ledit plan usure - distance parcourue car ledit seuil de puissance varie en fonction de la stratégie. La sous-zone correspondant à la première stratégie S1 est incluse dans ladite zone z de limitation et sous ladite droite d d'usure théorique et sous la droite de pente nulle dont l'ordonnée vaut ledit seuil d'usure maximum $w_{max}$ desdits balais auquel on a retranché ladite marge d'appréciation $\Delta$. La stratégie S1 a pour caractéristique essentielle de ne pas appliquer en permanence une limite à ladite puissance mécanique. Ainsi, une limitation de puissance n'est appliquée que si un seuil prédéterminé de puissance mécanique $P_{s1}$ (en kW) a été dépassé un nombre de fois $n_{S1}$ prédéterminé depuis le réveil du véhicule. Le nombre de dépassements n est enregistré par un calculateur du véhicule depuis son réveil et ledit nombre n de dépassements est réinitialisé à 0 à chaque endormissement dudit calculateur. Ladite stratégie S1 s'adapte donc à la conduite de chaque conducteur. Quand ledit nombre seuil $n_{S1}$ de dépassements est atteint la puissance mécanique maximale P (en kW) disponible pour le conducteur est limitée par une puissance mécanique maximale correspondant un pourcentage $pc_1$ (en %) de la puissance maximale en mode nominal $P_{max}$ (en kW) dudit moteur électrique, soit une puissance mécanique maximale autorisée par ladite stratégie S1: $P_{max,S1} = P_{max} * p_{c1}/100$ (en kW). Ledit seuil prédéterminé de puissance mécanique $P_{s1}$ peut être constant ou fonction de l'usure estimée w, par exemple ledit seuil $P_{S1}$ peut évoluer de façon inversement proportionnelle à l'usure estimée w. De même ledit nombre de dépassements $n_{S1}$ peut être constant ou fonction de ladite usure estimée w, par exemple ledit nombre seuil $n_{S1}$ de dépassements peut évoluer de façon inversement proportionnelle à ladite usure w, ainsi plus ladite usure estimée w est élevée moins le nombre seuil $n_{S1}$ de dépassements autorisés est élevé. La sous-zone de limitation dans laquelle s'applique une deuxième stratégie S2 est incluse dans ladite zone z de limitation et au-dessus de ladite droite d d'usure théorique et au-dessous la droite de pente nulle dont l'ordonnée vaut ledit seuil maximum d'usure $w_{max}$ desdits balais auquel on a retranché ladite marge d'appréciation $\Delta$ et au-dessous la droite définie comme la translatée de ladite droite d d'usure théorique d'un vecteur $(0, \Delta')$. La valeur de $\Delta'$ (en mm) est prédéterminée. Dans ladite sous-zone S2 une limitation de ladite puissance mécanique est appliquée en permanence. La limitation de puissance mécanique maximale autorisée par la stratégie S2 est choisie proportionnelle à l'écart d'usure par rapport à ladite droite d d'usure théorique. Ainsi, en prenant pour exemple un point P situé dans la sous-zone S2, ledit point P ayant pour abscisse la distance $D_P$ (en km) et pour ordonnée l'usure estimée $w_P$ (en mm), la puissance mécanique maximale autorisée par ladite stratégie S2 en ce-dit point P est :

$$P_{max,S2} = \max\{P_{sat,S2} \; ; \; P_{max} - [P_{d,S2} + f_{S2} \cdot (e)]\},$$

où

- $P_{sat,S2}$ (en kW) est un paramètre prédéterminé positif et strictement inférieur à $P_{max}$ , ledit paramètre $P_{sat,S2}$ étant la limite basse de la puissance mécanique maximale, ladite stratégie S2 ne limitant donc jamais ladite puissance mécanique maximale à une valeur inférieure audit paramètre $P_{sat,S2}$;
- $P_{d,S2}$ (en kW) est un paramètre prédéterminé positif ou nul et correspond à une limitation de puissance indépendante de ladite usure estimée $w_P$ dudit point P, il vaut $P_{max,S2}$ quand ledit point P est positionné sur ladite droite d d'usure théorique ;
- $f_{S2}$ (en kW/mm) est un paramètre prédéterminé homogène à une puissance divisée par une usure, ledit paramètre $f_{S2}$ est positif ou nul et représente le coefficient de proportionnalité de la limitation de puissance par rapport à l'écart d'usure entre l'usure estimée w et la droite d d'usure théorique ;
- e (en mm) est l'écart d'usure entre l'usure estimée $w_P$ dudit point P et l'usure théorique $w_{dP}$ (en mm) à ladite distance $D_P$; Ladite usure théorique $w_{dP}$ correspond à l'ordonnée de ladite droite d d'usure théorique à l'abscisse $D_P$;
- max {x, y} est l'opérateur maximum entre x et y.

La sous-zone de limitation dans laquelle s'applique une troisième stratégie S3 est incluse dans ladite zone z de limitation et est formée par la sous-zone entre ledit seuil maximum d'usure $w_{max}$ desdits balais et ladite droite définie comme la translatée de ladite droite d'usure théorique d'un vecteur (0, Δ') ainsi que par la sous-zone d'usure délimitée par ledit seuil maximum d'usure $w_{max}$ desdits balais et ledit seuil maximum d'usure $w_{max}$ desdits balais auquel on a retranché ladite marge d'appréciation Δ et ladite droite d'usure théorique. Ladite stratégie S3 s'active ainsi toujours après ladite stratégie S2. Soit $\overline{D}$ la distance totale (en km) parcourue par ledit véhicule avec lesdits balais à l'instant de la transition entre ladite stratégie S2 et ladite stratégie S3. De même que dans ladite sous-zone S2 une limitation de ladite puissance mécanique $P_{max,S3}$ (en kW) est appliquée en permanence dans la sous-zone S3. Ainsi, en prenant pour exemple un point P' situé dans la sous-zone S3, ladite puissance mécanique maximale autorisée par ladite stratégie S3 en ce-dit point P est :

$$P_{max,S3} = \max\{ P_{sat,S3} \; ; P_{max,S2}(\overline{D}) - [P_{d,S3} + f_{S3} \cdot (e')]\},$$

où

- $P_{max,S2}(\overline{D})$ (en kW) est la puissance maximale autorisée par ladite stratégie S2 à l'instant de la transition vers ladite stratégie S3 ;
- $P_{sat,S3}$ (en kW) est le paramètre prédéterminé positif, strictement inférieur à $P_{max}$ et inférieur ou égal à $P_{sat,S2}$ ; $P_{sat,S3}$ est la limite basse de la puissance mécanique maximale, ladite stratégie S3 ne limitant donc jamais ladite puissance mécanique maximale à une valeur inférieure audit paramètre $P_{sat,S3}$ ;
- $P_{d,S3}$ (en kW) est un paramètre prédéterminé positif ou nul correspondant à une limitation de puissance indépendante de ladite usure estimée w ;
- $f_{S3}$ (en kW/mm) est un paramètre prédéterminé homogène à une puissance divisée par une usure, ledit paramètre $f_{S3}$ est positif ou nul et représente le coefficient de proportionnalité de la limitation de puissance par rapport à l'écart d'usure entre ladite usure estimée w et ladite droite d d’usure théorique translatée d'un vecteur (0, Δ') ;
- e' (en mm) est l'écart d'usure entre l'usure estimée $w_{P'}$ dudit point P' et l'usure théorique dégradée dont la valeur correspond au minimum entre l'ordonnée à l'abscisse $D_{P'}$ (en mm) de ladite droite d d'usure théorique translatée d'un vecteur (0, Δ') et le seuil maximum d'usure desdits balais auquel on a retranché une marge d'appréciation.

La sous-zone de limitation dans laquelle s'applique une quatrième stratégie S4 est incluse dans ladite zone z de limitation et occupe le reste de ladite zone z à savoir la sous-zone au-dessus la droite de pente nulle dont l'ordonnée vaut ledit seuil maximum d'usure $w_{max}$ desdits balais auquel on a retranché ladite marge d'appréciation Δ et au-dessous de ladite droite d'usure théorique. De même que dans lesdites sous-zones S2 et S3 une limitation de puissance mécanique est appliquée en permanence dans la sous-zone S4. Ladite puissance mécanique maximale P disponible pour le conducteur est limitée par une puissance mécanique maximale correspondant un pourcentage $pc_4$ (en %) de la puissance maximale en mode nominal $P_{max}$ dudit moteur électrique, soit une puissance mécanique maximale autorisée par ladite stratégie S4: $P_{max,S4} = P_{max} \cdot p_{c4}/100$ (en kW). On paramètre ladite stratégie S4 de sorte que $p_{c4} \leq p_{c1}$. Quand ladite puissance mécanique maximale P disponible pour le conducteur est limitée par une puissance mécanique maximale d'une desdites stratégies S3 ou S4 un affichage invitant le conducteur à limiter ses accélérations pour préserver l'intégrité du moteur est affiché au tableau de bord. Dans le cas d'un véhicule disposant de différents modes de conduite tels que le mode éco, le mode normal, le mode sport, il est possible de n'appliquer ce procédé de limitation qu'à certains modes comme le mode sport par exemple. Enfin, le nombre de stratégies peut être supérieur, ou inférieur en combinant par exemple les zones des stratégies S1 et S4 ensemble.

D'autres modes de réalisation sont envisageables, notamment on peut utiliser d'autres unités de distance pour caractériser l'usure et/ou le seuil d'usure.

## Revendications

1. Procédé de limitation de l'usure des balais d'un moteur électrique d'un véhicule électrique ou hybride comportant:

   - une étape (100) d'estimation de l'usure desdits balais (w), où le procédé est **caractérisé par**
   - une étape (200) de limitation d'une puissance mécanique maximum autorisée pour ledit moteur en fonction de ladite usure estimée desdits balais (w) à partir d'un seuil d'usure desdits balais ($w_s$), où ledit seuil d'usure ($w_s$), au-delà duquel ladite limitation de puissance mécanique est effectuée, est fonction du temps cumulé d'utilisation desdits balais.

2. Procédé selon la revendication 1 **caractérisé en ce que** ledit temps cumulé d'utilisation desdits balais est pris égal à la distance totale parcourue par ledit véhicule avec lesdits balais.

3. Procédé selon la revendication 1 ou 2 **caractérisé en ce que** ladite étape (100) d'estimation de l'usure desdits balais (w) comporte au moins :

- une étape (110) de réception d'une requête de couple (T), d'une mesure du régime moteur (N) et d'une tension d'alimentation (V) aux bornes dudit moteur électrique,
- une étape (120) d'estimation d'un courant d'excitation (If) dudit moteur en utilisant une cartographie recevant en entrée ladite requête de couple (T), ladite mesure du régime moteur (N) et ladite tension (V),
- une étape (130) d'estimation de la vitesse d'usure des balais (v) en utilisant une cartographie recevant en entrée ledit courant d'excitation (If) estimé et ledit régime moteur (N),
- une étape de calcul d'usure des balais (w) par intégration temporelle de ladite vitesse d'usure des balais (v).

4. Procédé selon l'une quelconque des revendications 1 à 3 **caractérisé en ce que** l'étape (200) de limitation de la puissance mécanique comporte au moins :

- une étape (210) de calcul dudit seuil d'usure des balais ($w_s$),
- une étape (220) de comparaison de ladite usure des balais (w) estimée audit seuil ($w_s$) d'usure des balais,
- une étape (240) de limitation de ladite puissance mécanique dudit moteur lorsque ladite usure des balais (w) est supérieure audit seuil ($w_s$) d'usure des balais.

5. Procédé selon l'une quelconque des revendications précédentes **caractérisé en ce que** ledit seuil d'usure des balais ($w_s$), formant la limite inférieure de la zone (z) de limitation de puissance dans le plan temps d'utilisation - usure desdits balais, est défini par rapport à une droite (d) d'usure théorique desdits balais dont l'abscisse est ledit temps d'utilisation desdits balais, dont l'ordonnée à l'origine est l'usure nulle et dont l'ordonnée correspondant à un temps maximum prédéterminé d'utilisation desdits balais est l'usure maximum ($w_{max}$) desdits balais provoquant une panne immobilisante dudit moteur.

6. Procédé selon la revendication 5 **caractérisé en ce que** ledit seuil d'usure des balais ($w_s$) est une courbe constituée de trois segments de droite dont :

- le premier segment de droite est de pente nulle et son ordonnée vaut une valeur d'usure basse ($w_b$), en dessous de laquelle aucune limitation de puissance n'est nécessaire, et ce segment s'achève à son intersection avec ladite droite (d) d'usure théorique desdits balais,
- le second segment de droite est de pente inférieure ou égale à celle de ladite droite (d) d'usure théorique des balais, et s'achève à son intersection avec le troisième segmente de droite,
- le troisième segment de droite est de pente nulle et son ordonnée vaut ledit seuil maximum d'usure ($w_{max}$) desdits balais auquel on a retranché une marge d'appréciation ($\Delta$).

7. Procédé selon la revendication 6 **caractérisé en ce que** dans une sous - partie de la zone (z) de limitation de puissance située sous ladite droite (d) d'usure théorique desdits balais et sous le seuil maximum d'usure des balais ($w_{max}$) auquel on a retranché ladite marge d'appréciation ($\Delta$) une limitation de puissance n'est appliquée que si un seuil prédéterminé de puissance mécanique a été dépassé un nombre de fois prédéterminé depuis le réveil du véhicule.

8. Procédé selon la revendication 5 **caractérisé en ce que** la valeur de ladite limitation de puissance mécanique dudit moteur peut varier en fonction de la position de ladite usure (w) à un temps d'utilisation (t) donné dans ladite zone (z) de limitation de puissance.

9. Dispositif de limitation de l'usure des balais d'un moteur électrique d'un véhicule électrique ou hybride comportant:

- un moyen d'estimation (ME) de ladite usure des $b_{alais}$ (w), où le dispositif est **caractérisé par**
- un moyen de limitation (ML) d'une puissance mécanique maximum autorisée pour ledit moteur en fonction de ladite usure estimée (w) desdits balais à partir d'un seuil d'usure desdits balais ($w_s$), où ledit seuil d'usure ($w_s$), au-delà duquel ladite limitation de puissance mécanique est effectuée, est fonction du temps cumulé d'utilisation desdits balais.

10. Programme de calculateur comprenant des instructions pour mettre en oeuvre les étapes du procédé de limitation de l'usure des balais d'un moteur électrique d'un véhicule électrique ou hybride selon l'une quelconque des revendications 1 à 8, lorsque ledit programme est exécuté sur un ordinateur.

**Patentansprüche**

1. Verfahren zum Begrenzen des Verschleißes der Bürsten eines Elektromotors eines Elektrofahrzeugs oder Hybridfahrzeugs, das Folgendes umfasst:

   - einen Schritt (100) zum Abschätzen des Verschleißes der Bürsten (w), wobei das Verfahren **gekennzeichnet ist durch**
   - einen Schritt (200) zum Begrenzen einer maximalen mechanischen Leistung, die für den Motor zugelassen ist, in Abhängigkeit vom abgeschätzten Verschleiß der Bürsten (w) anhand eines Verschleißschwellenwerts der Bürsten ($w_s$), wobei der Verschleißschwellenwert ($w_s$), über dem die Begrenzung der mechanischen Leistung durchgeführt wird, eine Funktion der kumulierten Verwendungszeit der Bürsten ist.

2. Verfahren nach Anspruch 1, **dadurch gekennzeichnet, dass** die kumulierte Verwendungszeit der Bürsten gleich der gesamten durch das Fahrzeug mit den Bürsten zurückgelegten Strecke genommen wird.

3. Verfahren nach Anspruch 1 oder 2, **dadurch gekennzeichnet, dass** der Schritt (100) zum Abschätzen des Verschleißes der Bürsten (w) zumindest Folgendes umfasst:

   - einen Schritt (110) zum Empfangen einer Drehmomentanforderung (T), einer Messung der Motordrehzahl (N) und einer Versorgungsspannung (V) an den Anschlüssen des Elektromotors,
   - einen Schritt (120) zum Abschätzen eines Erregungsstroms (If) des Motors unter Verwendung einer Kartographie, die am Eingang die Drehmomentanforderung (T), die Messung der Motordrehzahl (N) und die Spannung (V) empfängt,
   - einen Schritt (130) zum Abschätzen der Verschleißgeschwindigkeit der Bürsten (v) unter Verwendung einer Kartographie, die am Eingang den abgeschätzten Erregungsstrom (If) und die Motordrehzahl (N) empfängt,
   - einen Schritt zum Berechnen des Verschleißes der Bürsten (w) durch zeitliche Integration der Verschleißgeschwindigkeit der Bürsten (v).

4. Verfahren nach einem der Ansprüche 1 bis 3, **dadurch gekennzeichnet, dass** der Schritt (200) zur Begrenzung der mechanischen Leistung zumindest Folgendes umfasst:

   - einen Schritt (210) zum Berechnen des Verschleißschwellenwerts der Bürsten ($w_s$),
   - einen Schritt (220) zum Vergleichen des abgeschätzten Verschleißes der Bürsten (w) mit dem Verschleißschwellenwert ($w_s$) der Bürsten,
   - einen Schritt (240) zum Begrenzen der mechanischen Leistung des Motors, wenn der Verschleiß der Bürsten (w) höher ist als der Verschleißschwellenwert ($w_s$) der Bürsten.

5. Verfahren nach einem der vorangehenden Ansprüche, **dadurch gekennzeichnet, dass** der Verschleißschwellenwert der Bürsten ($w_s$), der die untere Grenze der Leistungsbegrenzungszone (z) im Plan Verwendungszeit - Verschleiß der Bürsten bildet, in Bezug auf eine theoretische Verschleißgerade (d) der Bürsten definiert ist, deren Abszisse die Verwendungszeit der Bürsten ist, deren Ordinate am Ursprung der Nullverschleiß ist und deren Ordinate, die einer vorbestimmten maximalen Verwendungszeit der Bürsten entspricht, der maximale Verschleiß ($w_{max}$) der Bürsten ist, der einen Blockierungsausfall des Motors hervorruft.

6. Verfahren nach Anspruch 5, **dadurch gekennzeichnet, dass** der Verschleißschwellenwert der Bürsten ($w_s$) eine Kurve ist, die aus drei Geradensegmenten besteht, von denen:

   - das erste Geradensegment eine Steigung von null aufweist und seine Ordinate einen niedrigen Verschleißwert ($w_b$) angibt, unter dem keine Leistungsbegrenzung erforderlich ist, und dieses Segment an seinem Schnittpunkt mit der theoretischen Verschleißgerade (d) der Bürsten endet,
   - das zweite Geradensegment eine Steigung aufweist, die geringer als oder gleich jener der theoretischen Verschleißgerade (d) der Bürsten ist und an seinem Schnittpunkt mit dem dritten Geradensegment endet,
   - das dritte Geradensegment eine Steigung von null aufweist und seine Ordinate den maximalen Verschleißschwellenwert ($w_{max}$) der Bürsten angibt, von dem eine Schätzspanne ($\Delta$) abgezogen wurde.

7. Verfahren nach Anspruch 6, **dadurch gekennzeichnet, dass** in einem Unterabschnitt der Leistungsbegrenzungszone (z), der unter der theoretischen Verschleißgerade (d) der Bürsten und unter dem maximalen Verschleißschwellenwert der Bürsten ($w_{max}$) liegt, von dem die Schätzspanne ($\Delta$) abgezogen wurde, eine Leistungsbegrenzung nur dann angewendet wird, wenn ein vorbestimmter Schwellenwert der mechanischen Leistung eine vorbestimmte Anzahl von Malen seit der Aktivierung des Fahrzeugs überschritten wurde.

8. Verfahren nach Anspruch 5, **dadurch gekennzeichnet, dass** der Wert der Begrenzung der mechanischen Leistung des Motors in Abhängigkeit von der Position des Verschleißes (w) zu einer gegebenen Verwendungszeit (t) in der Leistungsbegrenzungszone (z) variieren kann.

9. Vorrichtung zur Begrenzung des Verschleißes der Bürsten eines Elektromotors eines Elektrofahrzeugs oder Hybridfahrzeugs, die Folgendes umfasst:

   - ein Mittel (ME) zum Abschätzen des Verschleißes der Bürsten (w), wobei die Vorrichtung **gekennzeichnet ist durch**
   - ein Mittel (ML) zum Begrenzen einer maximalen mechanischen Leistung, die für den Motor zugelassen ist, in Abhängigkeit vom abgeschätzten Verschleiß (w) der Bürsten anhand eines Verschleißschwellenwerts der Bürsten ($w_s$), wobei der Verschleißschwellenwert ($w_s$), über dem die Begrenzung der mechanischen Leistung durchgeführt wird, eine Funktion der kumulierten Verwendungszeit der Bürsten ist.

10. Computerprogramm, das Befehle enthält, um die Schritte des Verfahrens zur Begrenzung des Verschleißes der Bürsten eines Elektromotors eines Elektrofahrzeugs oder Hybridfahrzeugs nach einem der Ansprüche 1 bis 8 auszuführen, wenn das Programm auf einem Computer ausgeführt wird.

**Claims**

1. Method for limiting the wear of the brushes of an electric motor of an electric or hybrid vehicle comprising:

   - a step (100) of estimation of the wear of said brushes (w),
   the method being **characterized by**
   - a step (200) of limiting of a maximum mechanical power authorized for said motor as a function of said estimated wear of said brushes (w) from a wear threshold of said brushes ($w_s$), said wear threshold ($w_s$), beyond which said mechanical power limiting is effected, being a function of the aggregate time of use of said brushes.

2. Method according to Claim 1, **characterized in that** said aggregate time of use of said brushes is taken to be equal to the total distance traveled by said vehicle with said brushes.

3. Method according to Claim 1 or 2, **characterized in that** said step (100) of estimation of the wear of said brushes (w) comprises at least:

   - a step (110) of reception of a torque request (T), of a measurement of the motor speed (N) and of a power supply voltage (V) at the terminals of said electric motor,
   - a step (120) of estimation of an excitation current (If) of said motor using a mapping receiving as input said torque request (T), said measurement of the motor speed (N) and said voltage (V),
   - a step (130) of estimation of the speed of wear of the brushes (v) using a mapping receiving as input said estimated excitation current (If) and said motor speed (N),
   - a step of computation of wear of the brushes (w) by temporal integration of said speed of wear of the brushes (v).

4. Method according to any one of Claims 1 to 3, **characterized in that** the step (200) of limiting of the mechanical power comprises at least:

   - a step (210) of computation of said wear threshold of the brushes ($w_s$),
   - a step (220) of comparison of said estimated wear of the brushes (w) to said wear threshold ($w_s$) of the brushes,
   - a step (240) of limiting of said mechanical power of said motor when said wear of the brushes (w) is greater than said wear threshold ($w_s$) of the brushes.

5. Method according to any one of the preceding claims, **characterized in that** said wear threshold of the brushes

($w_s$), forming the lower limit of the power limiting zone (z) in the time of use - wear of said brushes plane, is defined in relation to a straight line (d) of theoretical wear of said brushes for which the x axis is said time of use of said brushes, for which the y axis at the origin is the zero wear and for which the y axis corresponding to a predetermined maximum time of use of said brushes is the maximum wear ($w_{max}$) of said brushes provoking an immobilizing failure of said motor.

6. Method according to Claim 5, **characterized in that** said wear threshold of the brushes ($w_s$) is a curve composed of three straight segments in which:

- the first straight segment is of zero slope and its y axis valve is a low wear value ($w_b$), below which no power limiting is necessary, and this segment is completed at its intersection with said straight line (d) of theoretical wear of said brushes,
- the second straight segment is of a slope less than or equal to that of said straight line (d) of theoretical wear of the brushes, and is completed at its intersection with the third straight segment,
- the third straight segment is of zero slope and its y axis value is said maximum wear threshold ($w_{max}$) of said brushes from which an assessment margin ($\Delta$) has been subtracted.

7. Method according to Claim 6, **characterized in that**, in a sub-part of the power limiting zone (z) situated under said straight line (d) of theoretical wear of said brushes and under the maximum wear threshold of the brushes ($w_{max}$) from which said assessment margin ($\Delta$) has been subtracted, a power limiting is applied only if a predetermined threshold of mechanical power has been exceeded a predetermined number of times since the vehicle was reactivated.

8. Method according to Claim 5, **characterized in that** the value of said mechanical power limiting of said motor can vary as a function of the position of said wear (w) at a given time of use (t) in said power limiting zone (z).

9. Device for limiting the wear of the brushes of an electric motor of an electric or hybrid vehicle comprising:

- a means for estimating (ME) said wear of the brushes (w),
the device being **characterized by**
- a means for limiting (ML) a maximum mechanical power authorized for said motor as a function of said estimated wear (w) of said brushes from a wear threshold of said brushes ($w_s$), said wear threshold ($w_s$), beyond which said mechanical power limiting is effected, being a function of the aggregate time of use of said brushes.

10. Computer program comprising instructions for implementing the steps of the method for limiting the wear of the brushes of an electric motor of an electric or hybrid vehicle according to any one of Claims 1 to 8, when said program is run on a computer.

```
                    ┌─────────────────────────┐
                    │   réception de T, N, V   │────╮  110
                    └─────────────────────────┘    ╰
                                 │
                                 ▼
                    ┌─────────────────────────┐
                    │     Estimation de If     │────╮  120
                    └─────────────────────────┘    ╰
                                 │
   100                           ▼
                    ┌─────────────────────────┐
                    │    Estimation de la      │
                    │   vitesse d'usure des    │────╮  130
                    │        balais v          │    ╰
                    └─────────────────────────┘
                                 │
                                 ▼
                    ┌─────────────────────────┐
                    │   Calcul de l'usure des  │────╮  140
                    │        balais w          │    ╰
                    └─────────────────────────┘
   200                           │
                                 ▼
                    ┌─────────────────────────┐
                    │      Calcul de w_s       │────╮  210
                    └─────────────────────────┘    ╰
                                 │
                                 ▼
            OUI          ◇ w < w_s ? ◇────╮  220
             │
             ▼                   │ NON
   230  ┌──────────┐             ▼
        │ Balais OK │    ┌─────────────────────────┐
        └──────────┘    │     Activation de la     │
                        │  limitation de puissance │────╮  240
                        │        mécanique         │    ╰
                        └─────────────────────────┘
```

Fig. 1

T
N
V

C1
If
C2
v
I

ME

w

DIS

S1
S2
S3
S4

ML

P

Fig. 2

Fig. 3

Fig. 4

**EP 3 350 608 B1**

## RÉFÉRENCES CITÉES DANS LA DESCRIPTION

### Documents brevets cités dans la description

- US 5177419 A